# EUROPEAN PATENT APPLICATION

(11) **EP 3 351 954 A1**
(43) Date of publication of application: **25.07.2018**
(21) Application number: 17152410.1
(22) Date of filing: 20.01.2017
(51) Int. Cl.: G01R 31/40, G01R 27/16, G06F 1/28

(54) **POWER SUPPLY CHECK METHOD AND CORRESPONDING APPARATUS**

(71) Applicant: Verisure Sàrl, 1290 Versoix (CH)
(72) Inventor: BOOK, Johannes, 231 31 TRELLEBORG (SE); MANNERBERG, Gunnar, 217 42 MALMÖ (SE)
(74) Representative: Lindahl, Dan Emil

(57) **Abstract**

A method for use by an electronic product to check the quality of an external power supply connected to a power supply inlet of the electronic product with the aid of a power cable, the method comprising the following steps:
- measure repeatedly a first voltage over a first resistor of a voltage divider connected between the power supply inlet and ground;
- average the first voltage to create an averaged first voltage;
- activate a power consuming component of the electronic product;
- measure repeatedly a second voltage over the first resistor of the voltage divider connected between the power supply inlet and ground;
- average the second voltage to create an averaged second voltage;
- estimate the power supply and cable internal resistance based on the averaged first voltage and the averaged second voltage;
- compare the power supply and cable internal resistance with a predetermined threshold value, and
- signal, based on the comparison of the power supply and cable internal resistance with a predetermined threshold value, the result of the comparison.

## Description

### TECHNICAL FIELD

The present invention relates to the field of methods and devices for checking the power supply and/or the power supply cable for an electronic device powered from an external power supply. In particular, it relates to such methods of alarm and surveillance system units powered from such external power supplies.

### BACKGROUND

For electronic products that have a standard power interface (i.e. that can be supplied from various power sources), the actual power source sometimes need to be evaluated by the product, before the product assumes full functionality. Examples are cell phones because they can be connected to many brands and types of chargers and charger cables.

If not doing this evaluation, there is a risk that a poor power supply or a long or highly resistive cable may cause a too-high voltage drop, compromising the performance of the electronic product.

A typical and standard solution on how to evaluate the actual power source would be to implement a dummy load, which can be turned on and off by control circuitry, e.g., a microcontroller in the product. Furthermore, means to measure the incoming voltage from the microcontroller is necessary, usually just a resistor divider connected to an analog-to-digital converter (ADC) of the microcontroller. Typically, the microcontroller would turn on the dummy load briefly, measure the voltage and turn off the load. The voltage drop and the current through the dummy load determines the resistive path to and in the power supply, and thus the quality of the power supply. If the voltage drop is larger than a predetermined amount, the electronic product could signal this to a user or to a superior unit.

### SUMMARY OF THE INVENTION

The present application provides a solution to the technical problem of how to measure resistance i.e., voltage drop at a given current, in the power supply path at a low cost.

The known solution of using a dummy load that can be turned on and off by control circuitry is often a good enough solution but the inventor has come up with a solution that in particular applications may offer a more cost-efficient solution.

The inventive idea is to use a set of features or components already existing in an electronic product to measure the power supply quality, i.e., its combined internal resistance plus cable resistance.

For example, many product today are equipped with a microcontroller and LEDs. The microcontroller is advantageously configured to use the product LED's (one red and one green) instead of adding a dummy load.

The microcontroller is configured to use an already existing resistor divider for measuring the input voltage.

Further, the microcontroller is configured to use an extensive averaging algorithm in software to calculate the power supply resistance. Since the LEDs only draw ∼20 mA compared to a total product load of many times of that, the difference in voltage seen by just turning on the LEDs drowns in noise. However, the microcontroller is configured with averaging algorithms to handle this.

### BRIEF DESCRIPTION OF THE DRAWINGS

In order that the manner in which the above recited and other advantages and objects of the invention are obtained will be readily understood, a more particular description of the invention briefly described above will be rendered by reference to specific embodiments thereof which are illustrated in the appended drawings.

Understanding that these drawings depict only typical embodiments of the invention and are not therefore to be considered to be limiting of its scope, the invention will be described and explained with additional specificity and detail through the use of the accompanying drawings in which:
- Fig. 1: shows a circuit diagram of a power supply check circuit of an electronic product for checking the internal resistance of the external power supply

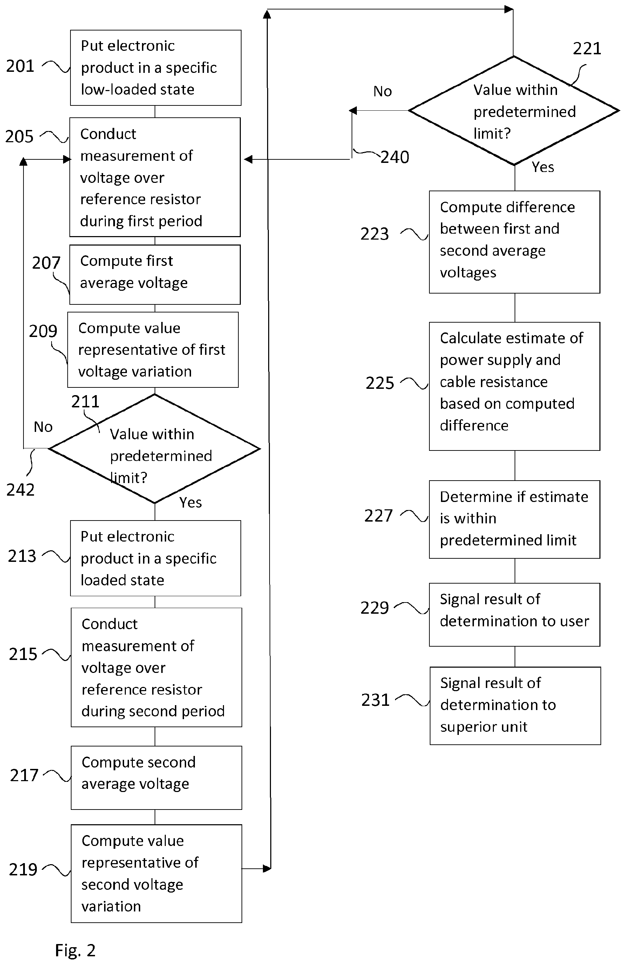

- Fig. 2: shows a flowchart of a method for checking the internal resistance of a power supply external to an electronic product.

### DETAILED DESCRIPTION

The inventive idea of the present invention is to use a software based method to enable use of components already being part of an electronic product to measure the quality of an external power supply connected to the product. With the term "quality" in this context is meant the resistive path to and in the power supply, or put in other words the resistance of resistive path from power supply.

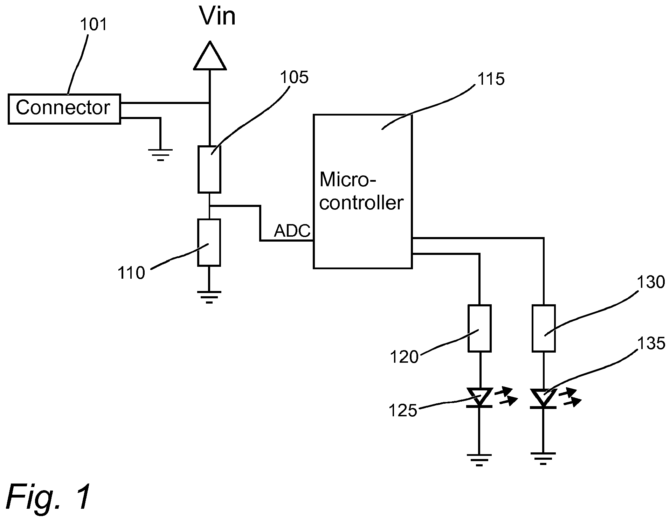

Now turning to figure 1, the product is assumed to comprise the following components:
- A power supply inlet 101;
- A voltage divider 105, 110 having a reference resistor 110;
- An analogue to digital converter 115;
- A processor 115;
- One or more components 120, 125, 130, 135 that can be turned on or off by the processor.

The analogue to digital converter and the processor may advantageously be combined as a microcontroller 115. The processor is configured to check the quality of a connected power supply with use of the method described below.

The method comprises the following steps:
- Setting 201 the electronic product in a specific low-loaded state;
- Conduct 205 repeated first measurements of a first voltage over the reference resistor during a first period
- Compute 207 a first average voltage being the average of the first repeated measurements;
- Compute 209 a first variation value representative of a first voltage variation;
- Check 211 if the first value of the first voltage variation is within predetermined limit, and if not redo first measurements;
- Put 213 electronic product in a specific loaded state;
- Conduct 215 repeated second measurements of a second voltage over the reference resistor during a second period;
- Compute 217 a second average voltage being the average of the second repeated measurements;
- Compute 219 a second variation value representative of a first voltage variation;
- Check 221 if the second variation value of the second voltage variation is within predetermined limit, and if not redo first and second measurements;
- Compute 223 difference between first and second average voltages
- Calculate 225 estimate of power supply and cable resistance based on computed difference;
- Determine 227 if estimate is within predetermined limit;
- Signal 229 result of determination to a user;
- Signal 231 result of determination to superior unit or entity;

The first average voltage may preferably be calculated as the mean. The second average voltage may also preferably be calculated as an estimate of the mean.

The first and the second variation values may preferably be calculated as an estimate of the variance.

In many applications, the resistance of resistive path from power supply should be low, typically below a few ohms, preferably below 2 ohms.

With the term "a specific low-loaded state" is meant a state that is known and wherein power consumption is comparably low and reasonably known, or can be estimated with, in the context, reasonable accuracy.

Fig. 1 shows a circuit diagram of a power supply check circuit of an electronic product for checking the internal resistance of the external power supply.
In this first example the product already comprises two light emitting diodes.

The product is configured to use the product LED's (one red and one green) instead of adding a dummy load. The product is further configured to use an already existing resistor divider for measuring the voltage.
The product is configured to use an extensive averaging algorithm in software to calculate the power supply resistance.

Since the LEDs only draw approximately 20 mA, compared to a total product load being approximately 20 to 40 times that value, the difference in voltage seen by just turning on the LEDs is likely to be drowned in noise. However, the inventors have made use of an averaging algorithm in software to average repeated measurements to make visible also very small differences between a first averaged voltage measured without activated LEDs and a second averaged voltage measured with activated LEDs.

## Claims

1. A method for use by an electronic product to check the quality of an external power supply connected to a power supply inlet of the electronic product with the aid of a power cable, the method comprising the following steps:
- measure repeatedly a first voltage over a first resistor of a voltage divider connected between the power supply inlet and ground;
- average the first voltage to create an averaged first voltage;
- activate a power consuming component of the electronic product;
- measure repeatedly a second voltage over the first resistor of the voltage divider connected between the power supply inlet and ground;
- average the second voltage to create an averaged second voltage;
- estimate the power supply and cable internal resistance based on the averaged first voltage and the averaged second voltage;
- comparing the power supply and cable internal resistance with a predetermined threshold value, and
- signalling, based on the comparison of the power supply and cable internal resistance with a predetermined threshold value, the result of the comparison.

2. The method of claim 1 further comprising the steps of:
- calculate a first variation value representative of variation in first voltage measurements;
- compare the first variation value with a predetermined threshold;
- redo measurements of first voltage if first variation value is above predetermined threshold;

3. The method of claim 1 or 2 further comprising the steps of:
- calculate a second variation value representative of variation in second voltage measurements;
- compare the second variation value with a predetermined threshold;
- redo measurements of first voltage and second voltage if second variation value is above predetermined threshold;

4. The method of any of claims 1 to 3 wherein the step of averaging is equivalent of estimating the mean.

5. The method of claim 2 or 3 wherein calculating a variation value is performed by calculating an estimate of the variance.

6. An electronic product comprising
- A power supply inlet;
- A voltage divider having a reference resistor;
- An analogue to digital converter;
- A processor;
- One or more components that can be turned on or off by the processor
**characterised in that** the processor is configured to check the quality of an external power supply according to the method of claim 1.
